(19) Europäisches Patentamt
European Patent Office
Office européen des brevets

(11) **EP 1 956 707 A1**

(12) **EUROPEAN PATENT APPLICATION**

(43) Date of publication:
**13.08.2008 Bulletin 2008/33**

(51) Int Cl.:
**H03H 17/00** *(2006.01)*

(21) Application number: **07250534.0**

(22) Date of filing: **09.02.2007**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK RS**

(71) Applicant: **Afa Technologies, Inc.**
**Hsin Tien**
**Taipei County 231 (TW)**

(72) Inventor: **Liang, Chih-Chihuan**
**Sindian City, Taipei County 231**
**Taiwan, R.O.C. (TW)**

(74) Representative: **Chamberlain, Alan James**
**Haseltine Lake**
**Redcliff Quay**
**120 Redcliff Street**
**Bristol BS1 6HU (GB)**

(54) **Signal interpolation apparatus and method**

(57)    A signal interpolation apparatus and method are provided, wherein symmetry and linear properties are exploited to simplify high order LaGrange interpolators. In digital systems, a fixed system clock is usually used. If a sampling rate needs to be changed, one useful method is to use an interpolation apparatus to create new samples from original data. LaGrange interpolation apparatus is a simple and highly accurate method for implementing finite input response (FIR) fractional delay filters, and is one of the most attractive interpolator implementations since it requires a fewer number of multiplications and additions for coefficient generation than other methods. However, the complexity of LaGrange interpolator increases exponentially with the order. The disclosed method can be used to significantly reduce complexity and power consumption while maintaining the same performance.

FIG.1

**Description**

BACKGROUND OF THE INVENTION

Field of the Invention

The present invention relates to a signal interpolation apparatus. More particularly, the present invention relates to a signal interpolation apparatus and method for simplifying a high order LaGrange interpolator by exploiting symmetry and linear properties.

Description of Related Art

In digital systems, a fixed system clock frequency is usually used. Therefore, when a sampling rate needs to be changed, an interpolator is used to create new samples from original data. For example, the solid line in FIG. 1 represents an analog waveform. The samples of circular dots in FIG 1 may be obtained through a sampling clock $T_1 = 7 / 64(\mu s)$ , while the samples of square dots in FIG 1 may be obtained through a sampling clock $T_2 = 7/48(\mu s)$ . FIGs. 2 and 3 merely show the sampling results in the sampling periods $T_1$ and $T_2$, respectively.

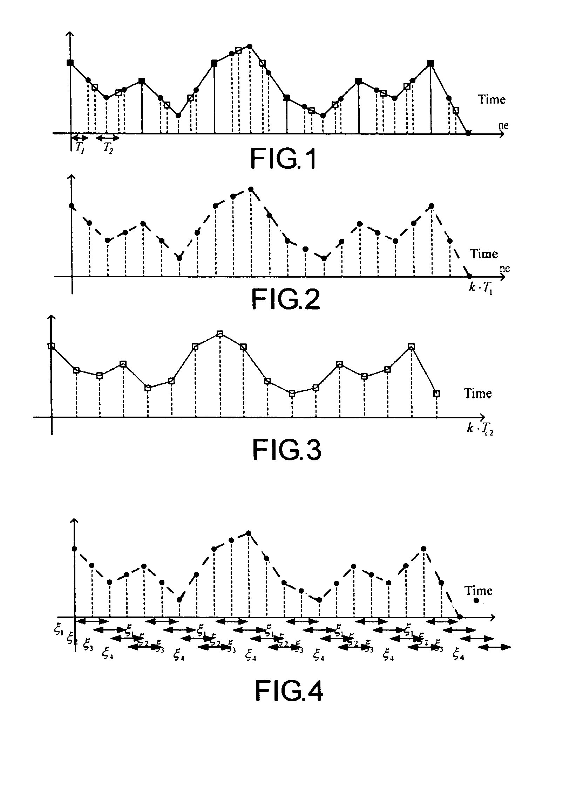

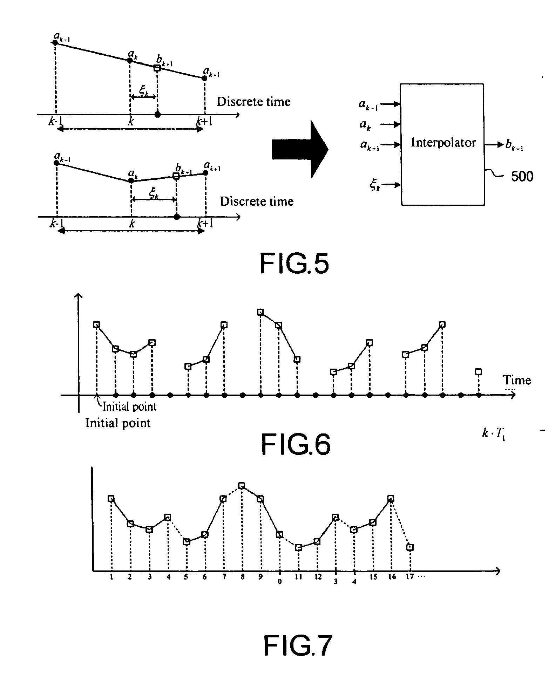

When the sampling rate is changed from $T_1$ to $T_2$ , i.e., the samples of the square dots are recreated from the sampling results of the circular dots, a quadratic interpolator with a fractional delay controller is used. The sampling clock compensation changed from $T_1$ to $T_2$ is $\dfrac{T_2 - T_1}{T_1} = \dfrac{1}{3}$ . Fractional delay values $\xi_1 = \dfrac{1}{3}, \; \xi_2 = \dfrac{2}{3},$ $\xi_3 = \dfrac{3}{3} = 1$ , and $\xi_4 = \dfrac{4}{3}$ between two sampling clock signals appear periodically, as shown in FIG. 4, and these values are automatically calculated through the delay controller. An interpolator 500 generates new data $b_{k+1}$ by using original data $a_{k-1}$, $a_k$, $a_{k+1}$ and the fractional delay values provided by the delay controller, as shown in FIG. 5.

When the interpolator finds the fractional delay value $\xi_4 = \dfrac{4}{3}$, the output thereof is masked (i.e., output 0), as shown in FIG 6. Since $\xi_4$ is larger than 1, it is unsuitable for the interpolator to use this value to create new samples, and the accuracy is lower than the other three fractional delay values.

The data in FIG. 6 is connected in series after the masked dots are removed, as shown in FIG. 7. The waveform in FIG. 7 is the same as that in FIG. 3. Therefore, if the interpolator is an ideal one, the sampling data of the square dots may be recreated by using the sampling data of the circular dots in FIG. 1. As a result, the accuracy of the interpolator determines the quality of the performance of sampling rate conversion.

LaGrange interpolator is a member of a simple and highly accurate finite input response (FIR) fractional delay filter, and is one of the most attractive interpolator implementations since it requires a fewer number of multiplications and additions for updating a coefficient than other methods, wherein the coefficient is obtained from Equation (1):

$$h(m, D) = \prod_{\substack{k=0 \\ k \ne m}}^{N} \frac{D - k}{m - k} \text{ , m=0, 1, 2, } \dots \text{N (1)}$$

N represents the order of the filter, and D represents the fractional delay.

The prior arts most related to the implementation of LaGrange interpolator are described as follows. US Patent Publication No. US6766338B1, entitled "High Order LaGrange Sample Rate Conversion Using Tables for Improved Efficiency", uses tables to store the coefficients obtained through calculation (by Equation (1)) in advance. Although the mentioned patent is applied to high order LaGrange interpolators, the fractional delay D is not arbitrary, and only predetermined values corresponding to D are suitable. Therefore, such an application is only for the sampling rate conversion with a fixed rate or rough delay control. US Patent Publication No. US5812608, entitled "Method and Circuit Arrangement for Processing Received Signal", uses a well-known Farrow structure to achieve the LaGrange interpolator. Such a structure is only applicable to the circumstance that the order N is a small odd number (especially N<=3), and with regard to the high order LaGrange interpolator, the complexity thereof becomes very high. As a result, the Farrow structure is unsuitable for highly accurate and high order LaGrange interpolators.

In view of the above, if coefficients h(0,D)~ h(N,D) are generated through Equation (1) by using the prior arts, at least $(N+1)\cdot(N-1) = N^2 -1$ multipliers, $N\cdot(N+1) = N^2+N$ dividers, and $N$ subtracters are needed. The whole LaGrange interpolator needs at least $N^2+N$ multipliers, $N^2+N$ dividers, $N$ subtracters, and N adders. When the order N is large $(N\geq3)$, the complexity of the interpolator implemented by the prior arts is greatly increased. Therefore, it has become an important topic of the design of high order LaGrange interpolators that how to further simplify the calculation of the LaGrange coefficient and set the fractional delay D at random.

SUMMARY OF THE INVENTION

Accordingly, the present invention is directed to provide a signal interpolation apparatus and method, wherein the symmetry property is similar to the linear property, thereby greatly reducing the hardware complexity of the high order LaGrange interpolation apparatus.

Based upon the aforementioned and other objectives, the signal interpolation apparatus provided by the present invention comprises a delay line, a coefficient generator, a symmetric combiner, and a T combiner. The delay line receives original data x(n) and outputs original data x(n), x(n-1), ..., x(n-N), wherein x(n) represents the $n_{th}$ original data, and N represents the order of the interpolation calculation. The coefficient generator provides coefficients $\tilde{S}_m(D)$, $w_1(D) = K_a \cdot \hat{M}(D)$, $w_2(D) = (D - (a +1))$, and $w_3(D) = (D - a)$ according to a fractional delay value D, wherein m represents an integer larger than 0 and smaller than or equal to N, $\tilde{S}_m(D)=\tilde{r}_m\cdot D+\tilde{g}_m$, $\tilde{r}_m$ and $\tilde{G}_m$ are constants, a is a real number,

$$K_a = \prod_{\substack{n=0 \\ n \neq a}}^{N} \frac{1}{a-n}, \quad \text{and} \quad \hat{M}(D) = \prod_{\substack{k=0 \\ k \neq a,a+1}}^{N} (D-k) \quad . \quad \text{The symmetric combiner calculates}$$

$$\sum_{m=0}^{(a-1)} \left[ (-1)^{m+1} \cdot \left( \tilde{S}_m(D) \cdot x(n-m) - \tilde{S}_{(N-m)}(D) \cdot x(n-(N-m)) \right) \right] \quad \text{and outputs a calculation result SC\_}$$

out. The T combiner calculates $w_1(D)\cdot\{w_2(D)\cdot\{w_3(D)\cdot SC\_out+x(n-a)\}-w_3(D)\cdot x(n-a-1)\}$ and outputs new data y(n).

From another point of view, the present invention provides a signal interpolation method, for performing the interpolation calculation on the original data x(n), x(n-1), ..., x(n-N) according to the fractional delay value D, so as to obtain the new data y(n), wherein N represents the order of the interpolation calculation. The signal interpolation calculation comprises the following steps. First, the coefficients $\tilde{S}_m(D)\equiv\tilde{r}_m\cdot D+\tilde{g}_m$, $w_1(D) = K_a\cdot \hat{M}(D)$, $w_2(D)=(D-(a+1))$, and $w_3(D) = (D - a)$ are calculated according to the fractional delay value D, wherein m is an integer larger than 0 and smaller than or equal to N, $\tilde{r}_m$ and $\tilde{G}_m$ are constants, and a is a real number, $K_a = \prod_{\substack{n=0 \\ n \neq a}}^{N} \frac{1}{a - n}$ and

$$\hat{M}(D) = \prod_{\substack{k=0 \\ k \neq a,a+1}}^{N} (D-k) \cdot \text{Afterward,}$$

$$\sum_{m=0}^{(a-1)} \left[ (-1)^{m+1} \cdot \left( \tilde{S}_m(D) \cdot x(n-m) - \tilde{S}_{(N-m)}(D) \cdot x(n-(N-m)) \right) \right] \quad \text{is calculated to claim the calculation}$$

result SC\_out. Then, $w_1(D)\cdot\{w_2(D).\{w_3(D).SC\_out+x(n-a)\}-w_3(D)\cdot x(n-a-1)\}$ is calculated to obtain the new data y(n).

In the present invention, the symmetry property is similar to the linear property, thereby greatly reducing the hardware complexity of the high order LaGrange interpolation apparatus.

In order to make the aforementioned and other objectives, features, and advantages of the present invention comprehensible, preferred embodiments accompanied with figures are described in detail below.

BRIEF DESCRIPTION OF THE DRAWINGS

FIG 1 is a waveform graph of generally sampling an analog waveform through different sampling periods.

FIGs. 2 and 3 merely show the sampling results in the sampling periods $T_1$ and $T_2$, respectively.

FIG. 4 shows that the fractional delay values $\xi_1 = \dfrac{1}{3}$, $\xi_2 = \dfrac{2}{3}$, $\xi_3 = \dfrac{3}{3} = 1$, and $\xi_4 = \dfrac{4}{3}$ in FIG 1 appear periodically.

FIG 5 shows that a common interpolator generates the new data $b_{k+1}$ by using the original data $a_{k-1}$, $a_k$, $a_{k+1}$ and the fractional delay values provided by the delay controller.

FIG. 6 shows that the interpolator masks its output (i.e., output 0) when finding that the fractional delay values are larger than 1.

FIG 7 shows the waveform formed after the data in FIG. 6 is connected in series with the masked points being removed.

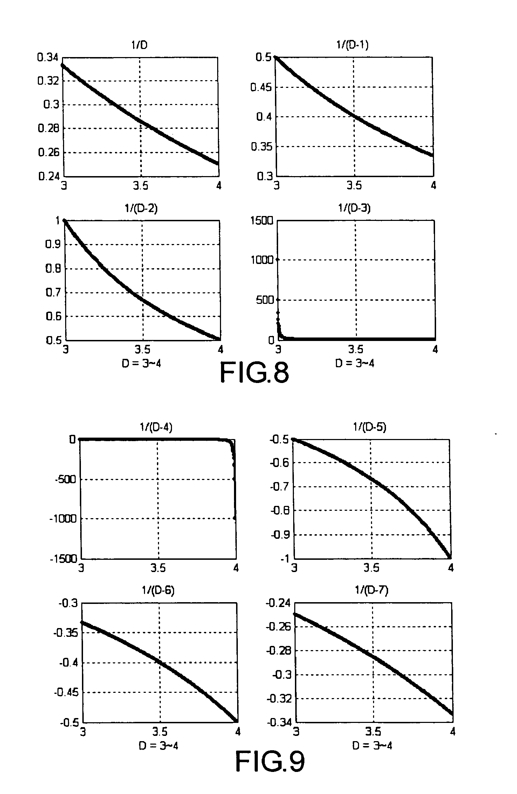

FIGs. 8 and 9 show the values of $Sr_0(D)$-$Sr_7(D)$ when N=7 and D=3-4 according to the present invention.

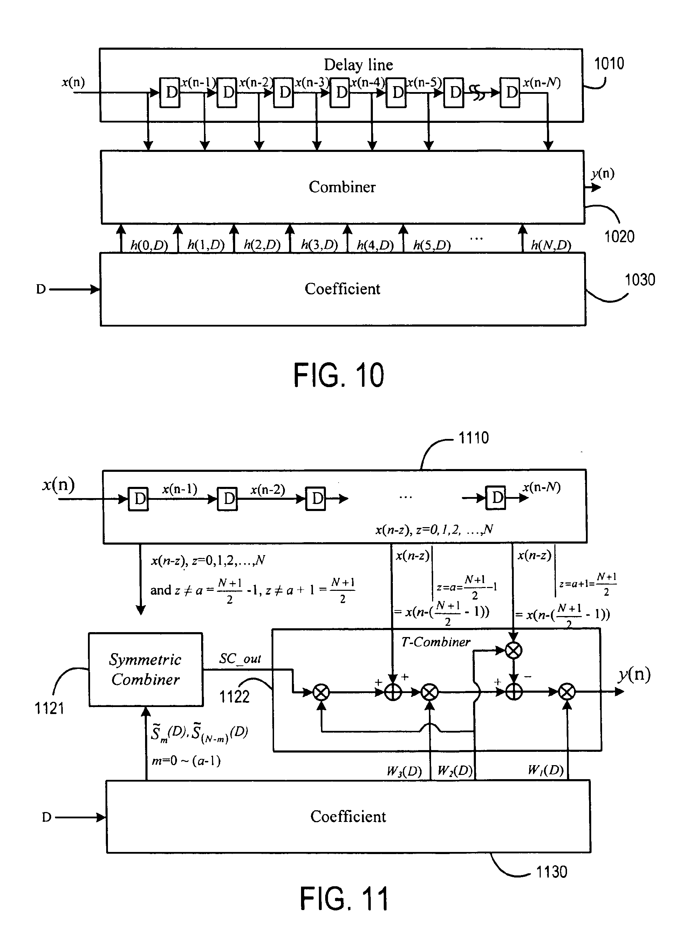

FIG 10 is a block diagram of the high order LaGrange interpolation apparatus according to an embodiment of the present invention.

FIG. 11 is a block diagram of the high order LaGrange interpolation apparatus according to another embodiment of the present invention.

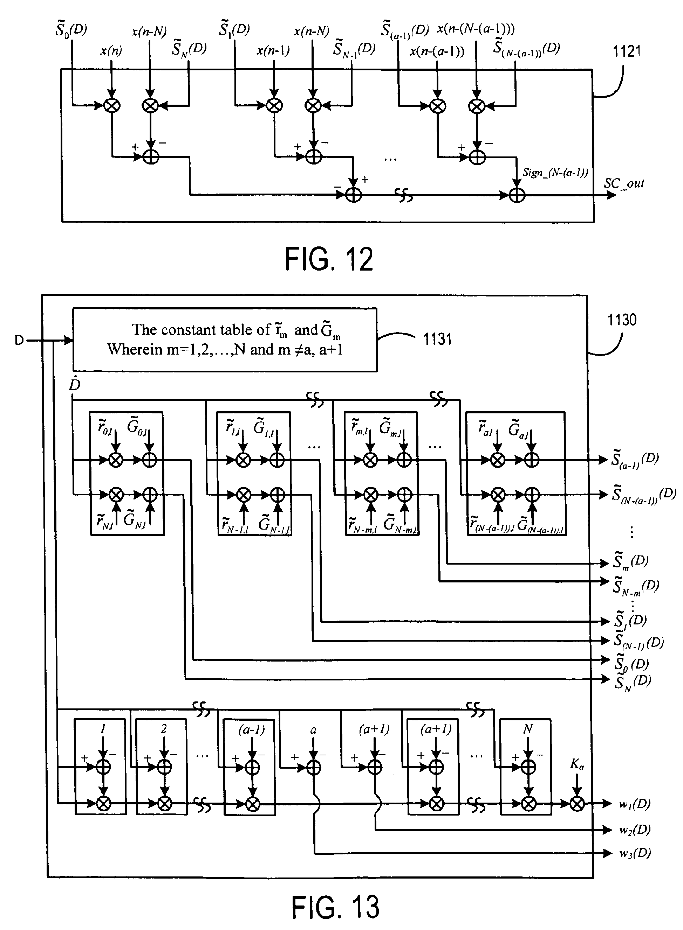

FIG. 12 shows an exemplary embodiment of the symmetric combiner in FIG. 11 according to the present invention.

FIG 13 shows an exemplary embodiment of the coefficient generator in FIG. 11 according to the present invention.

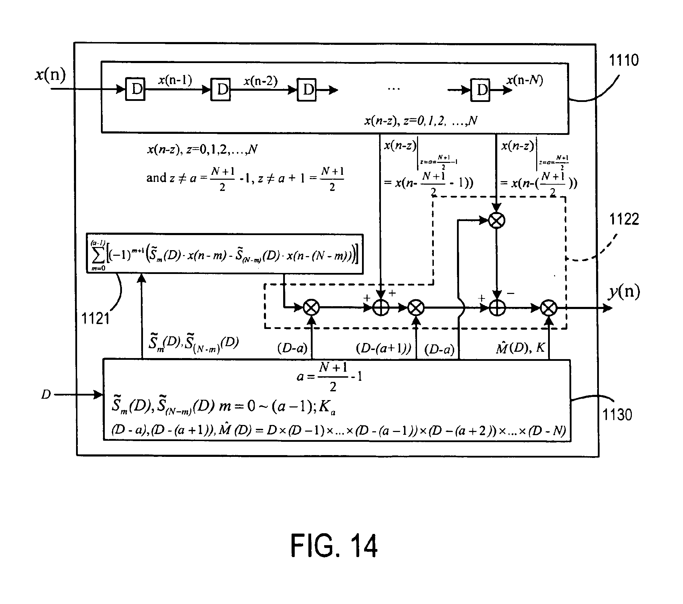

FIG 14 is a re-drawn view of FIG. 11.

DESCRIPTION OF EMBODIMENTS

In Equation (1), it is assumed that $D=a\sim(a+1)$, wherein $a \in \{0,1,2,...,N-2\}$, $N \geq 3$, and N is an odd integer. It is also assumed that:

$$\overset{\wedge}{M}(D) \equiv \frac{\prod\limits_{k=0}^{N}(D-k)}{[D-a]\times[D-(a+1)]} \qquad (2)$$

$$M(D) \equiv \prod\limits_{k=0}^{N}(D-k) = \overset{\wedge}{M}(D)\times[D-a]\times[D-(a+1)] \qquad (3)$$

$$C_m \equiv \prod\limits_{\substack{k=0 \\ k\neq m}}^{N} \frac{1}{m-k} \quad m=0,1,2,\ldots,N, \text{ wherein } C_m \text{ is a constant.} \qquad (4)$$

Equation (1) can be rewritten into Equation (5)
$$h(m,D) = \begin{cases} M(D) \times (\dfrac{1}{D-m}) \times C_m & ,m = 0,1,...,N \text{ and } m \neq a, m \neq (a+1) \\[2mm] \hat{M}(D) \times [D-(m+1)] \times C_m & ,m = a \\[2mm] \hat{M}(D) \times [D-(m-1)] \times C_m & ,m = (a+1) \end{cases} \tag{5}$$

It is assumed that $Sr_m(D) \equiv (\dfrac{1}{D-m})$, m=1,2,...,N and m≠a, m≠(a+1),

$$h(m,D) = \begin{cases} M(D) \times Sr_m(D) \times C_m & ,m = 0,1,...,N \text{ and } m \neq a, m \neq (a+1) \\[2mm] \hat{M}(D) \times [D-(m+1)] \times C_m & ,m = a \\[2mm] \hat{M}(D) \times [D-(m-1)] \times C_m & ,m = (a+1) \end{cases} \tag{6}$$

If *h(m,D)* is selected according to the aforementioned equation within the range of *D=a~(a+ 1)* and m=1,2,..., N,m≠a'm≠(a+1), $Sr_m$ (D) is similar to a straight line. FIGs. 8 and 9 are examples when N=7 and D=3-4.
Therefore, the linear approximation may be simply used as a divider. $Sr_m(D) \cong S_m(D) = -r_m \cdot D + g_m$ , wherein $r_m$, $g_m$ are constants, which is called linear property.

The ideal value of a is $(\frac{N+1}{2}-1)$. Given that $a = (\dfrac{N+1}{2}-1)$,

$$\hat{M}(D) = \dfrac{\prod\limits_{k=0}^{N}(D-k)}{\left[D-(\dfrac{N+1}{2}-1)\right] \times \left[D-\dfrac{N+1}{2}\right]}$$

$$M(D) \equiv \prod\limits_{k=0}^{N}(D-k) = \hat{M}(D) \times \left[D-(\dfrac{N+1}{2}-1)\right] \times \left[D-\dfrac{N+1}{2}\right]$$

$$
h(m, D) \cong \begin{cases} M(D) \times S_m(D) \times (-1)^{m+1} \times K_m & , m = 0,1,...,N \text{ and } m \neq \dfrac{N+1}{2} - 1, m \neq \dfrac{N+1}{2} \\[2mm] \overset{\wedge}{M}(D) \times [D - (m+1)] \times (-1)^{m+1} \times K_m & , m = \dfrac{N+1}{2} - 1 \\[2mm] \overset{\wedge}{M}(D) \times [D - (m-1)] \times (-1)^{m+1} \times K_m & , m = \dfrac{N+1}{2} \end{cases} \tag{7},
$$

In Equation (7), $\displaystyle K_m = \prod_{\substack{n=0 \\ n \neq m}}^{N} \frac{1}{m-n}$ , $\ m = 0,...,(\dfrac{N+1}{2} - 2)$ , and $K_m = K_{N-m}$, which is called symmetry property.

FIG 10 is a block diagram of the high order LaGrange interpolation apparatus according to an embodiment of the present invention. The interpolation apparatus performs an interpolation calculation on the original data x(n), so as to obtain the new data y(n). The interpolation apparatus includes a delay line 1010, a combiner 1020, and a coefficient generator 1030. The delay line 1010 includes a plurality of delayers DL to provide the original data x(n), x(n-1), ..., x(n-N) required by the interpolation calculation. The coefficient generator 1030 calculates coefficients h(0,D), h(1,D), ..., h(N,D) according to the fractional delay D, and provides the coefficients to the combiner 1020. The combiner 1020 combines the original data x(n), x(n-1), ..., x(n-N) and the coefficients h(0,D), h(1,D), ..., h(N,D), so as to output the new data y(n). The new data y(n) in FIG. 10 is represented as:

$$
y(n) = \sum_{m=0}^{N} h(m, D) \cdot x(n - m) \tag{8}
$$

h(m, D) in Equation (8) is replaced by Equation (7), and the following equation is obtained:

$$
y(n) \cong \overset{\wedge}{M}(D) \times
$$
$$
\left\{ (D-a) \cdot (D-(a+1)) \cdot \sum_{m=0}^{(a-1)} \left[ (-1)^{m+1} \cdot K_m \cdot \left( S_m(D) \cdot x(n-m) - S_{(N-m)}(D) \cdot x(n-(N-m)) \right) \right] \right.
$$
$$
\left. + K_a \cdot \left[ (D-(a+1)) \cdot x(n-a) - (D-a) \cdot x(n-(a+1)) \right] \right\} \Bigg|_{a = \left( \frac{N+1}{2} - 1 \right)}
$$

$$
= \overset{\wedge}{M}(D) \cdot K_a \cdot \left\{ (D-(a+1)) \cdot \left\{ (D-a) \cdot \right. \right.
$$
$$
\sum_{m=0}^{(a-1)} \left[ (-1)^{m+1} \cdot (\frac{K_m}{K_a}) \cdot \left( S_m(D) \cdot x(n-m) - S_{(N-m)}(D) \cdot x(n-(N-m)) \right) \right]
$$
$$
\left. \left. + x(n-a) \right\} - (D-a) \cdot x(n-(a+1)) \right\} \Bigg|_{a = \left( \frac{N+1}{2} - 1 \right)}
$$

$$
= \overset{\wedge}{M}(D) \cdot K_a \cdot \left\{ (D-(a+1)) \cdot \left\{ (D-a) \cdot \sum_{m=0}^{(a-1)} \left[ (-1)^{m+1} \cdot \left( \tilde{S}_m(D) \cdot x(n-m) - \tilde{S}_{(N-m)}(D) \cdot x(n-(N-m)) \right) \right] + x(n-a) \right\} \right. \tag{9}
$$
$$
\left. - (D-a) \cdot x(n-(a+1)) \right\} \Bigg|_{a = \left( \frac{N+1}{2} - 1 \right), \tilde{S}_m(D) = (\frac{K_m}{K_a}) \cdot S_m(D), \tilde{S}_{(N-m)}(D) = (\frac{K_m}{K_a}) \cdot S_{(N-m)}(D)}
$$

In Equation (9),

$$\tilde{S}_m(D) = \frac{K_m}{K_a} \cdot S_m(D) = \frac{K_m}{K_a} \cdot r_m \cdot D + \frac{K_m}{K_a} \cdot g_m \equiv \tilde{r}_m \cdot D + \tilde{G}_m \quad ,$$

$$m = 0,1,...,\frac{N+1}{2} - 2 \quad , \text{ and } m = \frac{N+1}{2} + 1,...,N \text{, wherein } r_m \text{ and } G_m \text{ are constants.}$$

Therefore, the combiner 1020 in FIG. 10 includes a symmetric combiner and a T combiner. FIG. 11 is a block diagram of the high order LaGrange interpolation apparatus according to another embodiment of the present invention. The interpolation apparatus includes a delay line 1110, a symmetric combiner 1121, a T combiner 1122, and a coefficient generator 1130. The delay line 1110 provides the original data x(n-a) and x(n-a-1) for the T combiner 1122, and the coefficient generator 1130 provides coefficients $W_1(D) = K_a \cdot \hat{M}(D)$ , $w_2(D)=(D-(a+1))$, and $w_3(D)=(D-a)$ for the T combiner 1122. The T combiner 1122 receives the output SC_out of the symmetric combiner 1121, i.e.,

$$\sum_{m=0}^{(a-1)} \left[ (-1)^{m+1} \cdot \left( \tilde{S}_m(D) \cdot x(n-m) - \tilde{S}_{(N-m)}(D) \cdot x(n-(N-m)) \right) \right], \text{ and then calculates } \hat{M}(D) \cdot K_a \cdot \{$$

(D-(a+1))·{(D-a)·SC_out + x(n - a))}- (D- a)·x(n-(a+1))}, thereby obtaining and outputting the new data y(n). Regardless of the order of the interpolation, the T combiner 1122 only needs four multipliers and two adders.

FIG 12 shows an exemplary embodiment of the symmetric combiner 1121 in FIG. 11 according to the present invention. By using the symmetry property, $S_0(D) \cdot x(n)$ is subtracted from $\tilde{S}_N(D) \cdot x(n - N)$ , $\tilde{S}_1(D) \cdot x(n -1)$ is subtracted from $\tilde{S}_{N-1}(D) \cdot x(n - (N -1))$, and the rest may be deduced by analogy. Finally, the calculation result SC_out of

$$\sum_{m=0}^{(a-1)} \left[ (-1)^{m+1} \cdot \left( \tilde{S}_m(D) \cdot x(n-m) - \tilde{S}_{(N-m)}(D) \cdot x(n-(N-m)) \right) \right] \text{ is output to the T combiner 1122.}$$

FIG. 13 shows an exemplary embodiment of the coefficient generator 1130 in FIG. 11 according to the present invention. The coefficient generator 1130 is used to generate coefficients $\tilde{S}_m(D)$, $w_1(D)$ , $w_2(D)$ , and $w_3(D)$, and provides the coefficients for both the symmetric combiner 1121 and the T combiner 1122. As described above, if $D_1 \le D \le D_{1+1}$, $\tilde{S}_m(D) = \tilde{r}_{m,1} \cdot \hat{D} + \tilde{G}_{m,1}$ , wherein $\hat{D} = (D - D_1)$, $1=0,1,...,q$, $m=0,1,...,N$, and $m \neq a, a+1$ . Herein, a is an ideal value

$$(\frac{N+1}{2} - 1), \quad K_m = \prod_{\substack{n=0 \\ n \neq m}}^{N} \frac{1}{m-n} \quad , \text{ and } \hat{M}(D) = \prod_{\substack{k=0 \\ k \neq a, a+1}}^{N} (D-k) . \text{ First, } \tilde{G}_{m,1} = \frac{\dfrac{K_m}{K_a}}{D_l - m} \quad \text{and}$$

$$\tilde{r}_{m,l} = \frac{-\dfrac{K_m}{K_a}}{(D_{l+1} - m) \cdot (D_l - m)} = \frac{-\tilde{G}_{m,l}}{(D_{l+1} - m)} \quad \text{are calculated according to the fractional delay D, wherein}$$

$D_1 \le D < D_{1+1}$. Since $r_{m,1}$ and $G_{m,1}$ are constants, in this embodiment, $r_{m,1}$ and $G_{m,1}$ must be calculated in advance and stored in the constant table 1131. According to the fractional delay D, the desired $\tilde{r}_{m,1}$ and $\tilde{G}_{m,1}$ are obtained from the constant table 1131 by table lookup, and then provided to the coefficient generator 1130 to calculate $\tilde{S}_m(D)$ .

FIG. 14 is a re-drawn view of FIG. 11. The coefficient multiplier 1130 needs

$$4 \times (a - 1 + 1) \Big|_{a = \frac{N+1}{2} - 1} = 4 \times \left( \frac{N+1}{2} - 1 \right) = 2N - 2 \text{ multipliers, } \hat{M}(D) \text{ needs N-2 multipliers, and the T com-}$$

biner 1122 needs 5 multipliers. Therefore, the high order interpolation apparatus in FIG. 14 needs (2N-2)+N-2+5 =3N+1 multipliers in total. In addition, the number of the subtracters/adders is

$$N + 2 + 3 \cdot \left( \frac{N+1}{2} - 1 \right) + \left( \frac{N+1}{2} - 1 - 1 \right) = \frac{5}{2}N + \frac{1}{2} + \frac{N}{2} + \frac{1}{2} - 2 = 3N - 1.$$

In view of the above, if the coefficients h(0, D) - h(N, D) are generated through Equation (1) by using the prior arts, at least (N + 1) - (N - 1) = $N^2$-1 multipliers, $N \cdot (N+1) = N^2 + N$ dividers, and N subtracters are needed. The whole LaGrange interpolator needs at least $N^2 + N$ multipliers, $N^2 + N$ dividers, N subtracters, and N adders. When the order N is large (N $\geq$ 3 ), the complexity of the interpolator implemented by the prior arts is greatly increased. In these embodiments of the present invention, the method of simplifying the high order LaGrange interpolation apparatus symmetrically and linearly may reduce the hardware complexity. As described in the above embodiments, only 3N+1 multipliers, 0 dividers, and 3*N-1 subtracters (or adders) are needed. The hardware complexities of the prior arts and the present invention are shown in Table 1.

Table 1 Comparative table about the hardware complexities of the LaGrange interpolators in the embodiments of the present invention and the prior arts.

| Hardware Complexity of Conventional LaGrange Interpolator | |
|---|---|
| Multiplier | $N^2 + N$ |
| Divider | $N^2 + N$ |
| Subtracter/adder | 2N |
| Hardware Complexity of LaGrange Interpolator in the Embodiments of the Present Invention | |
| Multiplier | 3$N$+1 |
| Divider | 0 |
| Subtracter/adder | 3$N$-1 |

Though the present invention has been disclosed above by the preferred embodiments, they are not intended to limit the present invention. Anybody skilled in the art can make some modifications and variations without departing from the spirit and scope of the present invention. Therefore, the protecting range of the present invention falls in the appended claims.

**Claims**

1.   A signal interpolation apparatus, comprising:

a delay line, for receiving original data x(n) and outputting the original data x(n), x(n-1), ..., x(n-N), wherein x(n) represents the $n_{th}$ original data, and N represents the order of interpolation calculation;
a coefficient generator, for providing coefficients $\widetilde{S}_m (D)$ , $w_1(D)=K_a \cdot \hat{M}(D)$ , $w_2(D)= (D-(a+1))$, and $w_3(D)=(D-a)$ according to a fractional delay value D, wherein m is an integer larger than 0 and smaller than or equal to N, $\widetilde{S}_m(D) \equiv \widetilde{r}_m \cdot D + \widetilde{g}_m$, $\widetilde{r}_m$ and $\widetilde{G}_m$ are constants, a is a real number, $K_a = \prod\limits_{\substack{n=0 \\ n \neq a}}^{N} \frac{1}{a-n}$ and

$$\hat{M}(D) = \prod\limits_{\substack{k=0 \\ k \neq a, a+1}}^{N} (D-k);$$

a symmetric combiner, coupled to the delay line and the coefficient generator, for calculating

$$\overset{(a-1)}{\underset{m=0}{\sum}}\left[(-1)^{m+1}\cdot\left(\widetilde{S}_m(D)\cdot x(n-m)-\widetilde{S}_{(N-m)}(D)\cdot x(n-(N-m))\right)\right]$$ and outputting a calculation result SC_out; and
a T combiner, coupled to the delay line, the coefficient generator, and the symmetric combiner, for calculating $w_1(D)\cdot\{w_2(D)\cdot\{w_3(D)\cdot SC\_out +x(n-a)\} - w_3(D)\cdot x(n-a-1)\}$ and outputting new data y(n).

2. The signal interpolation apparatus as claimed in claim 1, wherein a is $(\frac{N+1}{2}-1)$ .

3. The signal interpolation apparatus as claimed in claim 1, wherein the T combiner comprises:

 a first multiplier, for multiplying the calculation result SC_out by the coefficient $W_3(D)$;
 an adder, coupled to the first multiplier, for adding the output of the first multiplier by the original data x(n-a);
 a second multiplier, coupled to the adder, for multiplying the output of the adder by the coefficient $w_2(D)$;
 a third multiplier, for multiplying the original data x(n- (a+1)) by the coefficient $w_3(D)$;
 a subtracter, coupled to the second multiplier and the third multiplier, for subtracting the output of the second multiplier from the output of the third multiplier; and
 a fourth multiplier, coupled to the subtracter, for multiplying the output of the subtracter by the coefficient $w_1(D)$, so as to output the new data y(n).

4. The signal interpolation apparatus as claimed in claim 1, wherein the symmetric combiner comprises:

 a plurality of multipliers $MUT_i$, for multiplying the coefficients $\widetilde{S}_i(D)$ by the original data x(n-i), respectively, wherein i is an integer larger than or equal to 0 and smaller than a, or larger than N-a and smaller than or equal to N;
 a plurality of first subtracters $SUB1_j$, for subtracting the outputs of the multipliers $MUT_i$ from the outputs of the multipliers $MUT_{N-j}$, wherein j is an integer larger than or equal to 0 and smaller than a; and
 a plurality of second subtracters $SUB2_K$, k being an integer larger than 0 and smaller than a, wherein the second subtracter SUB2, subtracts the output of the first subtracter $SUB1_0$ from the output of the first subtracter $SUB1_1$, and the other subtracters $SUB2_k$ subtract the outputs of the second subtracters $SUB2_{k-1}$ from the outputs of the first subtracters SUB1k, respectively.

5. The signal interpolation apparatus as claimed in claim 1, wherein the coefficient generator comprises a constant table for storing the constants $r_m$ and $G_m$.

6. A signal interpolation method, for performing interpolation calculation on the original data x(n), x(n-1), ..., x(n-N) according to a fractional delay value D, thereby obtaining new data y(n), wherein N represents the order of the interpolation calculation, the signal interpolation method comprising:

 calculating coefficients $\widetilde{S}_m(D)=\widetilde{r}_m\cdot D+\widetilde{g}_m$ , $w_1(D) = Ka\cdot\hat{M}(D)$, $w_2(D)=(D-(a+1))$, and $w_3(D) = (D - a)$ according to the fractional delay value D, wherein m is an integer larger than 0 and smaller than or equal to N, $\widetilde{r}_m$ and $\widetilde{G}_m$

 are constants, and a is a real number, $K_a = \overset{N}{\underset{\substack{n=0\\n\neq a}}{\prod}}\frac{1}{a-n}$ , $\hat{M}(D)=\overset{N}{\underset{\substack{k=0\\k\neq a,a+1}}{\prod}}(D-k);$

 calculating $$\overset{(a-1)}{\underset{m=0}{\sum}}\left[(-1)^{m+1}\cdot\left(\widetilde{S}_m(D)\cdot x(n-m)-\widetilde{S}_{(N-m)}(D)\cdot x(n-(N-m))\right)\right]$$

 to obtain a calculation result SC_out; and
 calculating $w_1(D)\cdot\{w_2(D)\cdot\{w_3(D).SC\_out+x(n-a))-w_3(D)\cdot x(n-a-1))$ to obtain the new data y(n).

7. The signal interpolation method as claimed in claim 6, wherein a is $(\frac{N+1}{2} - 1)$.

8. The signal interpolation method as claimed in claim 6, further comprising:

   providing a constant table, for storing the constants $\tilde{r}_m$ and $\tilde{G}_m$.

FIG.1

FIG.2

FIG.3

FIG.4

**FIG.5**

**FIG.6**

**FIG.7**

FIG.8

FIG.9

FIG. 10

FIG. 11

FIG. 12

FIG. 13

FIG. 14

**European Patent Office**

**EUROPEAN SEARCH REPORT**

Application Number

EP 07 25 0534

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| D,A | US 5 812 608 A (VAELIMAEKI VESA [FI] ET AL) 22 September 1998 (1998-09-22) * column 3, line 56 - column 7, line 7; figures 2,3 * ----- | 1-8 | INV. H03H17/00 |
| D,A | US 6 766 338 B1 (HANDLEY STEPHEN R [US] ET AL) 20 July 2004 (2004-07-20) * the whole document * ----- | 1-8 | |
| D,A | WO 99/60701 A (UNIV DELFT TECH [NL]; COENEN ANTONIUS JOHANNES ROBER [NL]) 25 November 1999 (1999-11-25) * page 8, line 2 - page 11, line 12; figure 3 * ----- | 1-8 | |
| | | | **TECHNICAL FIELDS SEARCHED (IPC)** H03H G06F |

The present search report has been drawn up for all claims

| Place of search | Date of completion of the search | Examiner |
|---|---|---|
| The Hague | 23 July 2007 | De La Pinta, Luis |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 07 25 0534

This annex lists the patent family members relating to the patent documents cited in the above-mentioned European search report.
The members are as contained in the European Patent Office EDP file on
The European Patent Office is in no way liable for these particulars which are merely given for the purpose of information.

23-07-2007

| Patent document cited in search report | | Publication date | Patent family member(s) | | Publication date |
|---|---|---|---|---|---|
| US 5812608 | A | 22-09-1998 | EP | 0741472 A2 | 06-11-1996 |
| | | | FI | 952186 A | 06-11-1996 |
| US 6766338 | B1 | 20-07-2004 | NONE | | |
| WO 9960701 | A | 25-11-1999 | AU | 3854199 A | 06-12-1999 |
| | | | NL | 1009198 C2 | 19-11-1999 |

EPO FORM P0459

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6766338 B1
- US 5812608 A